Europäisches Patentamt

European Patent Office

Office européen des brevets

(19)

(11) Veröffentlichungsnummer : **0 104 354
B1**

(12)    # EUROPÄISCHE PATENTSCHRIFT

(45) Veröffentlichungstag der Patentschrift :
01.10.86

(21) Anmeldenummer : 83107364.8

(22) Anmeldetag : 27.07.83

(51) Int. Cl.⁴ : **G 01 R 15/06**, **H 01 G   4/28**

(54) **Kapazitive Betriebsanzeige für Mittelspannungs-Garnituren.**

(30) Priorität : 27.08.82 DE 3231908

(43) Veröffentlichungstag der Anmeldung :
04.04.84 Patentblatt 84/14

(45) Bekanntmachung des Hinweises auf die Patenterteilung : 01.10.86 Patentblatt 86/40

(84) Benannte Vertragsstaaten :
AT BE CH DE IT LI NL SE

(56) Entgegenhaltungen :
FR-A- 2 102 531
GB-A- 2 060 258
US-A- 3 829 742

(73) Patentinhaber : **Kabel- und Lackdrahtfabriken GmbH
Casterfeldstrasse 62-64
D-6800 Mannheim 24 (DE)**

(72) Erfinder : **Fenske, Dieter,Dipl.-Ing.
Luisenstrasse 15
D-6800 Mannheim 24 (DE)**
Erfinder : **Kurz, Adolf
Hardtwaldtring 98
D-6836 Oftersheim (DE)**

(74) Vertreter : **Schnabel, Hartmut, Dr.-Ing. et al
Kabel- und Lackdrahtfabriken GmbH Patentabteilung
Postfach 1265
D-6800 Mannheim 1 (DE)**

EP 0 104 354 B1

Jouve, 18, rue St-Denis, 75001 Paris, France

**Beschreibung**

Die Erfindung betrifft eine kapazitive Betriebsanzeige für Mittelspannungs-Garnituren, bei denen ein das Kabel aufnehmender Isolierkörper aus elastischem Kunststoff von einer äußeren schwachleitenden Schicht umgeben ist, wobei der Isolierkörper eine Ausstülpung aufweist für eine kapazitive Meßstelle mit einem metallischen Körper mit einem leitenden Außenkontakt, der in einem vorbestimmten Abstand von den spannungsführenden Teilen endet.

Eine derartige kapazitive Betriesanzeige ist in einem vor dem Jahr 1980 ohne Datumsangabe gedrückten Elastimold-Garnituren-Prospekt unter der Typen-Nr. (K) 154 LR dargestellt.

Im Falle vollisolierter Anlagen und zugehöriger Kabelanschlüsse besteht keine Möglichkeit, vor Beginn einer etwa notwendigen Demontage eine starre Erdung vorzunehmen, da keine im Betrieb Spannung führenden Teile zugänglich sind. Der Monteur hat nicht ohne weiteres die Möglichkeit, mit ausreichender Sicherheit den Betriebszustand zu bestimmen. Daher sind zur Bestimmung edes Betriebszustandes kapazitive Meß- und Anzeige-Einrichtungen bei Kabelgarnituren bekanntgeworden, wie z. B. im Falle des obengenannten Winkelsteckers von Elastimold. Dort besteht die Möglichkeit, mit einer Isolierstange in Kombination mit einer geeigneten Anzeigevorrichtung letztere mit dem Außenkontakt der kapazitiven Meßstelle nach Entfernen einer Schutzkappe zu kontaktieren. Damit wird festgestellt, ob die Anlage ein- oder ausgeschaltet ist. Eine Daueranzeige bzw. eine ortsferne Anzeige ist hier nicht vorgesehen. Weiterhin besteht die Abschirmung lediglich aus einer Schicht von schwachleitfähigem Material, was in bestimmten Betriebsfällen keinen ausreichenden Berührungsschutz bieten kann.

Dementsprechend liegt der vorliegenden Erfindung die Aufgabe zugrunde, die Betriebssicherheit derartiger Kabelanschlüsse für vollgekapselte Anlagen zu erhöhen und zwar einmal im Sinne eines verbesserten Berührungsschutzes. Zum anderen sollten für die unterschiedlichen Betriebs- und Montage-Situationen die jeweils geeigneten Anzeigemöglichkeiten zur Verfügung gestellt werden, z. B. vor Ort ebenso wie in der Schaltwarte.

Die vorgenannte Aufgabe wird bei einer Betriebsanzeige der eingangs genannten Art gemäß der Erfindung dadurch gelöst, daß der Isolierkörper von einem metallischen Gehäuse umgeben ist, das eine Öffnung mit einer Isolierung aufweist, die oberhalb eines metallischen Federkontaktes liegt, der in einem Zwischenraum zwischen Isolierkörper und Gehäuse vom Außenkontakt der kapazitiven Meßstelle zum Gehäuse verläuft und durch federndes Anliegen entweder mit dem Gehäuse oder mit einem in das Gehäuse eingelassenen Kontakt einer Anzeige-Einrichtung oder deren Zuleitung leitend verbunden ist.

Bei einer vorteilhaften Ausführungsform ist vorgesehen, daß in das Gehäuse ein Kontaktstift einer am Gehäuse befestigten Buchse mit Koaxialkabelanschluß für eine ortsferne Anzeige eingelassen ist, an dem der Federkontakt federnd anliegt.

Weiterhin empfiehlt es sich, im Falle des Nichtbenutzens des Koaxialkabelanschlusses diesen mittels einem Kurzschlußbügel abzudecken, der zum Gehäuse führt. Damit ist eine etwaige Berührung eines spannungsführenden Teiles ausgeschlossen.

Weitere vorteilhafte Ausführungsformen sind in Unteransprüchen gekennzeichnet.

Die Erfindung wird im folgenden anhand eines Ausführungsbeispieles näher erläutert, aus dem sich weitere Merkmale und Vorteile entnehmen lassen. In der zugehörigen Zeichnung zeigt

Figur 1 einen Längsschnitt durch einen Winkelstecker, in dem alle wesentlichen Bauteile dargestellt sind ;

Figur 2 einen Längsschnitt durch die eigentliche kapazitive Meßstelle im Detail und zwar mit BNC-Buchse ;

Figur 3 einen Teil-Längsschnitt durch die kapazitive Meßstelle mit im Gehäuse integrierter LCD-Anzeige.

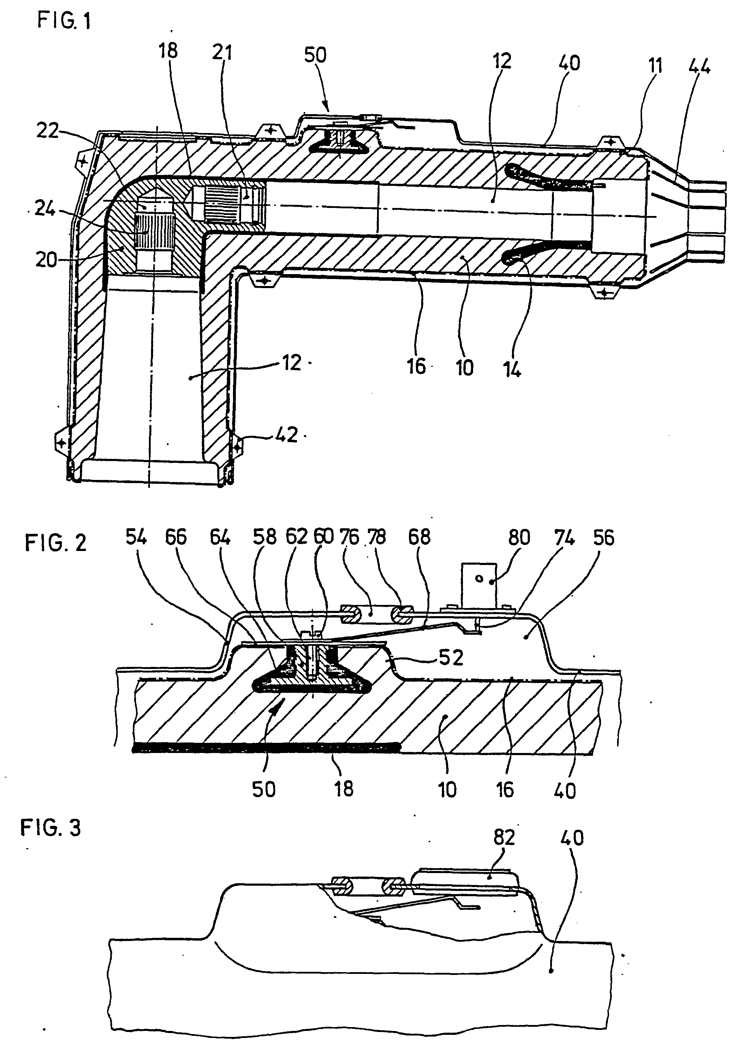

In Figur 1 ist der Isolierkörper 10 mit einer waagerechten Bohrung 12 und einer dazu rechtwinkelig durchlaufenden Bohrung 12 versehen, die von rechts her das abisolierte Kabel und von links unten her die Durchführung der Anlage aufnimmt. In den Isolierkörper 10 ist aus elektrischen Gründen ein schwachleitender Feldsteuerungstrichter 14 integriert, der aus gleichartigem Material wie der Isolierkörper selbst, z. B. aus Silikonkautschuk (mit Rußzusatz) bestehen kann oder auch aus Metall. Weiterhin ist der Isolierkörper 10, zumindest an den elektrisch beanspruchten Stellen, mit einer äußeren schwachleitenden Schicht 16 umgeben und weist weiterhin im Anschlußbereich der Bohrung 12 eine innere schwachleitende Schicht 18 auf.

Schließlich weist der Isolierkörper 10 noch Abstandshalter wie angeformte Noppen oder ringförmige Verdickungen 11 auf, zur Sicherstellung eines für thermische Ausdehnungen zweckmäßigen geeigneten Abstandes von dem Gehäuse 40. Das Gehäuse 40 ist im Falle des Beispieles zweischalig ausgebildet und weist Laschen 42 auf zur Verbindung der Gehäusehälften. Leitereingangsseitig ist das Gehäuse 40 konisch verengt und weist axial verlaufende Schlitze 44 auf zur Anpassung des Winkelsteckergehäuses an den Außendurchmesser des Kabels. Gegebenenfalls ist eine Anbringung einer Schelle möglich. Das Gehäuse kann eine vorbereitete Stelle aufweisen zur Verbindung mit der Kabelabschirmung oder Erde. Durch das Anliegen der Verdickungen 11 am Gehäuse 40 ist auch die schwachleitende äußere Schicht 16 geerdet.

Das Eckverbindungsstück 20 weist zwei winkel-und durchmessergerechte Bohrungen 21, 22 auf, die üblicherweise Kontaktlamellen 24 enthalten. Die kabelseitige Bohrung 21 ist bevorzugt verriegelbar ausgebildet. Die Mittelachsen der Bohrungen 21 und 22 schließen einen Winkel von 90° ein. Das Eckverbindungsstück 20 kann aus einem Stück gegossen sein, insbesondere aus Kupfer. Es ist jedoch auch möglich, dieses aus zwei Teilen herzustellen. Die Form des Eckverbindungsstückes 20 ist vorteilhafterweise so gewählt, daß ein kleinerer an die kabelseitige Bohrung 21 angepaßter Zylinder rechtwinklig in einen größeren an den Enddurchmesser der Durchführung der Anlage angepaßten Zylinder des Eckverbindungsstückes 20 übergeht. In die Bohrung 22 ist ein Adapterstift zur Verbindung mit der Durchführung, in die Bohrung 21 ein Leiteranschlußbolzen mit einem hülsenförmigen Teil zum Anschluß an den Leiter durch Preßverbindung einsteckbar. Durch die vorgesehene Zwischenschaltung eines Adapterstiftes zwischen Eckverbindungsstück und leitendem Anschlußstück der Durchführung ist es möglich, sowohl Steck- als auch Schraubverbindungen zu realisieren. Im Falle einer Steckverbindung wird in das Eckverbindungsstück 20 ein zylindrischer Adapterstift eingesteckt, im Falle einer Verschraubung wird ein Adapterstift benutzt, der durchführungsseitig ein Außengewinde aufweist. Im Montagefall wird zuerst dieser Adapterstift mit dem Anschluß der Durchführung verschraubt, und sodann wird die ansonsten fertigmontierte Winkelgarnitur auf dieses Adapterstück aufgesteckt.

Wie Figur 2 zeigt, ist die kapazitive Meßstelle 50 in eine Ausstülpung 52 des Isolierkörpers 10 eingebettet. Entsprechend ist eine Ausbuchtung 54 im Gehäuse 40 notwendig, die einen Zwischenraum 56 zwischen Isolierkörper und Gehäuse schafft. Dieser Zwischenraum 56 kann — wie gezeichnet — im wesentlichen neben der Ausstülpung, er kann aber auch ausschließlich über der Ausstülpung 52 liegen. Die kapazitive Meßstelle 50 weist einen metallischen Körper 58 auf mit etwa hutförmigen Querschnitt. Er endet in Form einer Scheibe in einem vorbestimmten Abstand von der schwachleitenden Schicht 18. Dieser metallische Körper 58 weist weiterhin einen Außenkontakt 60 auf. Im einfachsten Fall ist eine Schraube 62 von oben in eine Sacklochbohrung des metallischen Körpers 58 eingelassen. Der metallische Körper 58 kann seinerseits in eine schwachleitende Schicht 64 eingebettet sein, die aus Silikonkautschuk mit Rußzusatz hergestellt sein kann. Zur Isolierung des metallischen Körpers 58 bzw. der kapazitiven Meßstelle 50 gegenüber der schwachleitenden Schicht 16 dient einerseits die Maßnahme, daß die schwachleitende Schicht 16 im Bereich der Ausstülpung 52 fehlt, andererseits wird unter die Schraube 62 eine Isolierscheibe 66 gelegt, um den auf dieser befindlichen durch die Schraube 62 befestigten Federkontakt 68 gegen die geerdete schwachleitende Schicht 16 zu isolieren. Das Gehäuse 40 weist oberhalb und im Bereich des Federkontaktes 68 eine Öffnung 76 auf, die zwecks Isolierung des in der Regel aus Metallblech bestehenden Gehäuserandes einen Isolierring mit Außennut oder ein Manschettenring 78 aufweist. Der metallische oder aus gutleitendem Material bestehende Federkontaktarm 68 verläuft vom Außenkontakt 60 des kapazitiven Meßpunktes 50 zu einem durch das Gehäuse in den Zwischenraum 56 eintretenden Kontaktstift 74, an dem der Federkontakt 68 federnd anliegt. Bei Fehlen des Kontaktstiftes 74 in der einfachsten Ausführungsform würde der Federkontakt 68 direkt federnd am Gehäuse 40 anliegen. Der Kontaktstift 74 ist mit einer Anzeige-Einrichtung oder deren Zuleitung leitend verbunden. Das bedeutet, daß am Gehäuse 40 eine Anschlußbuchse, etwa eine BNC-Buchse 80 mit Anschluß für ein Koaxialkabel, befestigt sein kann oder aber auch an eine Anzeige-Einrichtung, die entweder außerhalb des Gehäuses liegt oder aber in das Gehäuse integriert ist (vgl. hierzu Figur 3). Von der Buchse 80 aus ist mittels Kabel auch eine Weiterleitung und Messung an einer ortsfernen Stelle, z. B. in einer Schaltwarte, möglich. Soweit der Anschluß eines Kabels, insbesondere eines Koaxialkabels, an die vorhandene Buchse 80 entfällt, soll ein Kurzschlußbügel zum Gehäuse 40 hin vorgesehen werden zwecks Erdung des nicht benutzten Anschlusses. Andernfalls besteht die Gefahr einer Potential-Berührung.

Figur 3 zeigt als Teil-Längsschnitt eine in das Gehäuse 40 eingelassene LCD-Anzeige 82.

Die erfindungsgemäße kapazitive Betriebsanzeige bietet im einzelnen folgende Möglichkeiten zur Anzeige des Betriebszustandes:

Diskontinuierliche Anzeige

Die kapazitive Meßstelle 50 soll im Betrieb mit dem metallischen Gehäuse 40 niederohmig verbunden sein. Dies geschieht über den Federkontakt 68, der mit der Schraube 62 im metallischen Körper 58 der Meßstelle 50 befestigt ist und aufgrund einer mechanischen Vorspannung an dem anderen Ende, insbesondere am metallischen Gehäuse 40, anliegt.

Mit einer geeigneten Meßspitze einer Isolierstange, wie sie auf dem Markt erhältlich sind, kann über die im Gehäuse 40 vorgesehene Bohrung 76 der Federkontakt 68 durch Druck vom Erdpotential des metallischen Gehäuses 40 getrennt werden. Die Isolierscheibe 66 verhindert dabei den Kontakt zur ebenfalls geerdeten schwachleitenden äußeren Schicht 16 des Isolierkörpers 10. Durch den Isolierring 78 wird eine Berührung zwischen Meßspitze und metallischem Gehäuse 40 ausgeschlossen. Das im Betrieb an dieser Stelle vorhandene Zwischenpotential kann nun mit einer geeigneten Einrichtung, die mit der Isolierstange kombiniert ist, gemessen und abgelesen werden.

Kontinuierliche Anzeige

An das metallische Gehäuse 40 ist die Buchse 80, z. B. eine BNC-Buchse, befestigt, die den Anschluß einer Koaxialleitung ermöglicht. Der Schirm der Leitung liegt gemäß Ausbildung der Buchse auf dem Potential des metallischen Gehäuses 40, d. h. auf Erdpotential. Der Innenleiter ist über den Federkontakt 68 und den Kontaktstift 74 der Buchse 80 mit der kapazitiven Meßstelle 50 niederohmig verbunden. Dadurch ist es möglich, das im Betrieb vorhandene Zwischenpotential der Meßstelle 50 an einem beliebigen Ort anzuzeigen. Anstelle der Buchse 80 kann auch eine Anzeige, z. B. eine LCD-Anzeige 82, in das metallische Gehäuse 40 eingebaut werden.

Es besteht auch die Möglichkeit, im Bedarfsfalle unabhängig von einer angebrachten Anzeige die diskontinuierliche Anzeige zu verwenden.

**Patentansprüche**

1. Kapazitive Betriebsanzeige für Mittelspannungs-Garnituren, bei denen ein das Kabel aufnehmender Isolierkörper (10) aus elastischem Kunststoff von einer äußeren schwachleitenden Schicht (16) umgeben ist, wobei der Isolierkörper (10) eine Ausstülpung (52) aufweist für eine kapazitive Meßstelle (50) mit einem metallischen Körper (58) mit einem leitenden Außenkontakt (60), der in einem vorbestimmten Abstand von den spannungsführenden Teilen endet, dadurch gekennzeichnet, daß der Isolierkörper (10) von einem metallischen Gehäuse (40) umgeben ist, das eine Öffnung (76) mit einer Isolierung (78) aufweist, die oberhalb eines metallischen Federkontaktes (68) liegt, der in einem Zwischenraum (56) zwischen Isolierkörper (10) und Gehäuse (40) vom Außenkontakt (60) der kapazitiven Meßstelle (50) zum Gehäuse (40) verläuft und durch federndes Anliegen entweder mit dem Gehäuse (40) oder mit einem in das Gehäuse (40) eingelassenen Kontakt (74) einer Anzeige-Einrichtung oder deren Zuleitung leitend verbunden ist.

2. Kapazitive Betriebsanzeige für Mittelspannungs-Garnituren nach Anspruch 1, dadurch gekennzeichnet, daß in das Gehäuse (40) ein Kontaktstift (74) einer im Gehäuse (40) befestigten Buchse (80) mit Koaxialkabelanschluß für eine ortsferne Anzeige eingelassen ist, an dem der Federkontakt (68) federnd anliegt.

3. Kapazitive Betriebsanzeige für Mittelspannungs-Garnituren nach Anspruch 2, gekennzeichnet durch einen Kurzschlußbügel vom Koaxialkabelanschluß der Buchse (80) zum Gehäuse (40).

4. Kapazitive Betriebsanzeige für Mittelspannungs-Garnituren nach Anspruch 1, dadurch gekennzeichnet, daß eine Anzeige (82) komplett in oder am Gehäuse (40) eingebracht ist.

5. Kapazitive Betriebsanzeige für Mittelspannungs-Garnituren nach Anspruch 4, dadurch gekennzeichnet, daß als Anzeige eine LCD-Anzeige (82) vorgesehen ist.

6. Kapazitive Betriebsanzeige für Mittelspannungs-Garnituren nach einem der Ansprüche 1 bis 4, dadurch gekennzeichnet, daß der metallische Körper (58) einen etwa hutförmigen Querschnitt aufweist und nach innen in Form einer Scheibe endet, welche auf eine in den Isolierkörper (10) im Anschlußbereich des Kabels integrierte innere halbleitende Schicht (18) weist.

7. Kapazitive Betriebsanzeige für Mittelspannungs-Garnituren nach einem der Ansprüche 1 bis 6, dadurch gekennzeichnet, daß die schwachleitende äußere Schicht (16) auf dem Isolierkörper (10) im Bereich der kapazitiven Meßstelle (50) durch eine unterhalb des Federkontaktes (68) angeordnete Isolierscheibe (66) abgedeckt ist.

8. Kapazitive Betriebsanzeige für Mittelspannungs-Garnituren nach einem der Ansprüche 1 bis 7, dadurch gekennzeichnet, daß der metallische Körper (58) von einer schwachleitenden Schicht (64) umgeben ist, die aus gleichartigem Material besteht wie der Isolierkörper (10).

9. Kapazitive Betriebsanzeige für Mittelspannungs-Garnituren nach einem der Ansprüche 6 bis 8, dadurch gekennzeichnet, daß der Isolierkörper (10) aus Silikonkautschuk und die innere und äußere schwachleitende Schicht (18, 16) aus Silikonkautschuk mit Rußzusatz bestehen.

10. Kapazitive Betriebsanzeige für Mittelspannungs-Garnituren nach Anspruch 9, dadurch gekennzeichnet, daß das Gehäuse (40) im Bereich der kapazitiven Meßstelle (50) sowie des Federkontaktes (68) und des ggf. vorhandenen Kontaktstiftes (74) eine Ausbuchtung aufweist.

11. Kapazitive Betriebsanzeige für Mittelspannungs-Garnituren nach einem der Ansprüche 1 bis 10, dadurch gekennzeichnet, daß die Isolierung der Öffnung (76) des Gehäuses (40) als in die Öffnung (76) einsetzbarer Manschettenring (78) ausgebildet ist.

**Claims**

1. Capacitive operation display for medium voltage fittings, in which an insulating body (10) of elastic synthetic material, which holds the cable, is surrounded by an exterior, poorly conductive layer (16), in which the insulating body (10) has a protuberance (52) for a capacitive measuring point (50) with a metallic body (58) with a conductive external contact (60), which terminates at a predetermined distance from the live parts, characterized in that the insulating body (10) is surrounded by a metallic housing (40), which has an opening (76) with an insulation (78) which lies above a metallic spring contact (68) which runs in an intermediate space (56) between the insulating body (10) and housing (40) from the external contact (60) of the capacitive measuring point (50) to the housing (40) and through resilient abutting is conductively connected either with the housing (40) or with a contact (74) of a display device or lead thereof which is let into the housing (40).

2. Capacitive operation display for medium voltage fittings according to Claim 1, characterized in that let into the housing (40) there is a contact pin (74) of a socket (80), which is attached in the housing (40), with a coaxial cable connection for a remote display, against which pin the spring contact (68) rests resiliently.

3. Capacitive operation display for medium voltage fittings according to Claim 2, characterized by a short-circuiting bridge from the coaxial cable connection of the socket (80) to the housing (40).

4. Capacitive operation display for medium voltage fittings according to Claim 1, characterized in that a display (82) is placed completely in or against the housing (40).

5. Capacitive operation display for medium voltage fittings according to Claim 4, characterized in that an LCD display (82) is provided as the display.

6. Capacitive operation display for medium voltage fittings according to one of Claims 1 to 4, characterized in that the metallic body (58) has an approximately hat-shaped cross-section and terminates inwardly in the form of a disc which points towards an inner semi-conducting layer (18) integrated into the insulating body (10) in the connection region of the cable.

7. Capacitive operation display for medium voltage fittings according to one of Claims 1 to 6, characterized in that the poorly conductive outer layer (16) on the insulating body (10) is covered in the region of the capacitive measuring point (50) by an insulating plate (66) arranged beneath the spring contact (68).

8. Capacitive operation display for medium voltage fittings according to one of Claims 1 to 7, characterized in that the metallic body (58) is surrounded by a poorly conductive layer (64), which consists of a similar material to the insulating body (10).

9. Capacitive operation display for medium voltage fittings according to one of Claims 6 to 8, characterized in that the insulating body (10) consists of silicone rubber and the inner and outer poorly conductive layers (18, 16) consist of silicone rubber filled with carbon black.

10. Capacitive operation display for medium voltage fittings according to Claim 9, characterized in that the housing (40) has a bulge in the region of the capacitive measuring point (50) and also of the spring contact (68) and of the contact pin (74) which may be present.

11. Capacitive operation display for medium voltage fittings according to one of Claims 1 to 10, characterized in that the insulation of the opening (76) of the housing (40) is constructed as a sleeve ring (78) which can be inserted in the opening (76).

**Revendications**

1. Indication de fonctionnement capacitive pour connecteurs à moyenne tension, dans lesquels un corps isolant (10) en matière synthétique élastique, recevant le câble, est entouré par une couche externe (16) faiblement conductrice, le corps isolant (10) présentant un retroussement (52) pour une station de mesure capacitive (50) avec un corps métallique (58) possédant un contact externe conducteur (60), qui se termine à une distance prédéterminée des pièces sous tension, caractérisée en ce que le corps isolant (10) est entouré par un boîtier métallique (40), qui présente une ouverture (76) avec un isolement (78), qui se situe au-dessus d'un contact à ressort métallique (68), qui s'étend dans un espace intermédiaire (56) entre le corps isolant (10) et le boîtier (40), depuis le contact externe (60) de la station de mesure capacitive (50) jusqu'au boîtier (40) et est relié de manière conductrice, par application élastique, soit avec le boîtier (40), soit avec un contact (74) encastré dans le boîtier (40) d'un dispositif indicateur ou de son conducteur.

2. Indication de fonctionnement capacitive pour connecteurs à moyenne tension suivant la revendication 1, caractérisée en ce que dans le boîtier (40) est enchâssée une broche de contact (74) d'une douille (80) fixée dans le boîtier (40), avec raccord de câble coaxial pour une indication à distance, contre laquelle s'applique élastiquement le contact à ressort (68).

3. Indication de fonctionnement capacitive pour connecteurs à moyenne tension suivant la revendication 2, caractérisée par un étrier de court-circuit depuis le raccord de câble coaxial de la douille (80) jusqu'au boîtier (40).

4. Indication de fonctionnement capacitive pour connecteurs à moyenne tension suivant la revendication 1, caractérisée en ce qu'un affichage (82) est agencé complètement dans ou sur le boîtier (40).

5. Indication de fonctionnement capacitive pour connecteurs à moyenne tension suivant la revendication 4, caractérisée en ce qu'on prévoit en tant qu'affichage, un affichage à cristaux liquides (82).

6. Indication de fonctionnement capacitive pour connecteurs à moyenne tension suivant l'une des revendications 1 à 4, caractérisée en ce que le corps métallique (58) présente une section transversale approximativement en forme de chapeau et se termine intérieurement sous la forme d'un disque, qui présente une couche semiconductrice interne (18) intégrée dans le corps isolant (10) dans la zone de raccordement du câble.

7. Indication de fonctionnement capacitive pour connecteurs à moyenne tension suivant l'une des revendications 1 à 6, caractérisée en ce que la couche externe faiblement conductrice (16) sur le corps isolant (10) est recouverte au voisinage de la station de mesure capacitive (50) par une rondelle isolante (66) disposée en dessous du contact à ressort (68).

8. Indication de fonctionnement capacitive pour connecteurs à moyenne tension suivant l'une des revendications 1 à 7, caractérisée en ce que le corps métallique (58) est entouré par une couche faiblement conductrice (64) qui est constituée par la même matière que le corps isolant (10).

9. Indication de fonctionnement capacitive pour connecteurs à moyenne tension suivant l'une des revendications 6 à 8, caractérisée en ce que le corps isolant (10) est constitué par du caoutchouc au silicone, et les couches faiblement conductrices interne et externe (18, 16) par du caoutchouc au silicone avec addition de noir de fumée.

10. Indication de fonctionnment capacitive pour connecteurs à moyenne tension suivant la revendication 9, caractérisée en ce que le boîtier (40) présente au voisinage de la station de mesure capacitive (50) ainsi que du contact à ressort (68) et de la broche de contact (74) éventuellement présente, un renflement.

11. Indication de fonctionnement capacitive pour connecteurs à moyenne tension suivant l'une des revendications 1 à 10, caractérisée en ce que l'isolement de l'ouverture (76) du boîtier (40) est réalisé en tant qu'anneau à collet (78) pouvant être placé dans l'ouverture (76).

0 104 354

FIG. 1

FIG. 2

FIG. 3

1